# EUROPEAN PATENT APPLICATION

(11) **EP 0 546 823 A2**
(43) Date of publication of application: **16.06.1993**
(21) Application number: 92311244.5
(22) Date of filing: 09.12.1992
(51) Int. Cl.: G01R 33/04

(54) **Magnetometer**

(30) Priority: 11.12.1991 IL 100344
(71) Applicant: THE STATE OF ISRAEL, MINISTRY OF DEFENSE, RAFAEL ARMAMENT DEVELOPMENT AUTHORITY, Haifa 31 021 (IL)
(72) Inventor: Netzer, Yishay, 20 142 (IL); Frankl, Efraim, Kiryat Motzkin 26 332 (IL)
(74) Representative: Hillier, Peter

(57) **Abstract**

A temperature stabilized flux-gate magnetometer including a core (12), preferably of ferromagnetic material, having a non-linear magnetization curve, an excitation winding (14) operatively associated with the core (12), an oscillator providing an AC excitation signal to the excitation winding (14) and a signal winding (16,18) operatively associated with the core (12) and providing an AC output signal generally proportional to the ambient magnetic field at the location of the core (12). The flux-gate magnetometer also includes apparatus for extracting from the AC output signal a magnetic field dependent DC signal, apparatus for feeding back the magnetic field dependent signal to the signal winding (16,18) in order to generate at the core (12) a magnetic field substantially opposite in sense and substantially equal in magnitude to the ambient magnetic field and apparatus for sensing a characteristic of the magnetic field dependent signal to provide an output indication of the ambient magnetic field at the core (12).

## Description

### FIELD OF THE INVENTION

The present invention relates to magnetometers and electrical compasses generally.

### BACKGROUND OF THE INVENTION

Various types of magnetometers are known in the art and are employed for direction finding as well as for various other purposes.

A summary of the field is described in a paper entitled "Recent Advances in Fluxgate Magnetometry" by Daniel J. Gordon, IEEE Trans. Magnetics Vol. Mag-8, p76, March, 1972, which is incorporated herein by reference.

Magnetometers of the prior art operate on the principle that when an alternating magnetic field is imposed on a non-linear, generally saturable magnetic material, the permeability of the material, µ, varies as a function of time. When such a material is subjected to a static magnetic field H, an alternating magnetic field B=µ*H results.

If such a material is placed in a sensor coil, a voltage will be induced in the coil which is proportional to derivative of B times the number of turns in the coil. The induced voltage will also be proportional to the cosine of the angle between the axis of the coil and the direction of the static field. Thus, if the static field is in the same direction as the axis of the coil, the induced voltage will be a maximum; if the two are perpendicular, no voltage will be induced in the coil.

If two perpendicular sensor coils are used, and if a static magnetic field exists in the plane of the axes of the coils (or has a component in that plane) the direction of the field can be determined. If one of the axes is considered as a reference, the induced voltage of the reference coil will be proportional to the cosine of the angle between its axis and the static field, while the voltage in the other coil will be proportional to the sine of the angle. The ratio between the output voltages can then be used to determine the angle of the static field. If, the field is static field is the earth's field and the device senses the horizontal component of the field, then the device is a compass.

If there is no static magnetic field then there will be no voltage induced in the sensor coils.

Using the outputs of three orthogonal coils the three dimensional direction can be determined.

The voltage generated in the sensor coil will generally have mainly even harmonics of the alternating current which causes the varying permeability.

It is further known to demodulate the induced voltage at the second harmonic in order to generate (after some filtering) a D.C. current or voltage which is substantially, but not exactly proportional to the magnitude of the respective component of the static magnetic field.

In a null type magnetometer, a high gain amplifier is used to amplify this voltage and the result is fed into a feedback coil which is parallel to the sensor coil in a direction which opposes the static field. If the amplifier gain is infinite, then the current in the feedback coil will stabilize at a value equal to that necessary to cancel the static field. This current, therefore will be exactly proportional to the static magnetic field.

### SUMMARY OF THE INVENTION

The present invention seeks to provide an improved magnetometer and an improved electrical compass.

In a preferred embodiment of the magnetometer of the present invention, the feedback coil is omitted. The amplified current is fed directly back into the sensor coil in a direction to oppose the static magnetic field. To avoid this current feeding back into the amplifier, a blocking circuit such as a capacitor is used to block the DC current from the input of the amplifier.

Preferably, the amplifier comprises an integrator having a very high gain. Such an amplifier has essentially an infinite gain for the DC component of the demodulated signal, which is proportional to the second harmonic voltage, and thus the static field, and acts as a low pass filter which discriminates against the other voltage components of the demodulated signal.

There is therefore provided in a preferred embodiment of the present invention a temperature stabilized flux-gate magnetometer comprising:
a core having a non-linear magnetization curve;
an excitation winding operatively associated with the oscillator providing an AC excitation signal to the excitation winding;
an oscillator providing an AC excitation signal to the excitation winding;
a signal winding operatively associated with the core and providing an AC output signal generally proportional to the ambient magnetic field at the location of said core;
means for extracting from said AC output signal a magnetic field dependent DC signal;
means for feeding back said magnetic field dependent signal to said signal winding means in order to generate at the core a magnetic field substantially opposite in sense and substantially equal in magnitude to the ambient magnetic field; and
means for sensing a characteristic of said magnetic field dependent signal to provide an output indication of the ambient magnetic field at said core.
a signal winding operatively associated with the core and providing an AC output signal generally proportional to the ambient magnetic field at the location of said core;
means for extracting from said AC output signal a magnetic field dependent DC signal;
means for feeding back said magnetic field dependent signal to said signal winding means in order to generate at the core a magnetic field substantially opposite in sense and substantially equal in magnitude to the ambient magnetic field; and
means for sensing a characteristic of said magnetic field dependent signal to provide an output indication of the ambient magnetic field at said core.

### BRIEF DESCRIPTION OF THE DRAWINGS

The present invention will be understood and appreciated more fully from the following detailed description, taken in conjunction with the drawings in which:
Fig. 1 is an exploded view illustration of part of a flux gate magnetometer constructed and operative in accordance with a preferred embodiment of the present invention;
Fig. 2 is a pictorial view of an assembled flux gate magnetometer of the type partially illustrated in Fig. 1;
Fig. 3 is a sectional illustration of the flux gate magnetometer of Fig. 2, taken along the lines III - III of Fig. 2;
Fig. 4 is a simplified block diagram illustration of the flux gate magnetometer of the present invention; and
Fig. 5 is an electrical schematic illustration of a preferred embodiment of the flux gate magnetometer of the present invention.

### DETAILED DESCRIPTION OF A PREFERRED EMBODIMENT

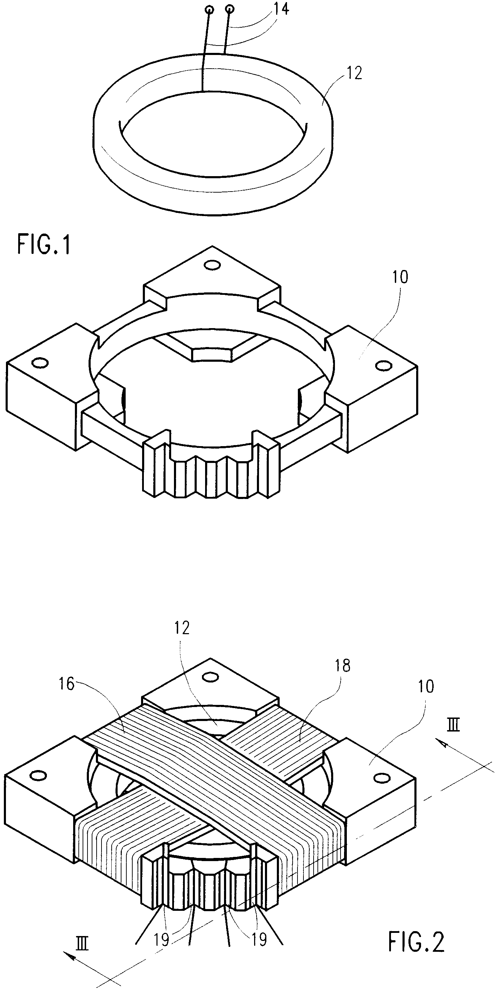

Reference is now made to Figs. 1 - 3, which illustrate the mechanical construction of a flux gate magnetometer constructed and operative in accordance with a preferred embodiment of the present invention. The magnetometer comprises a base element 10, which is preferably molded of an insulative material such as a reinforced polymer and defines a seating location for a ferromagnetic core 12 which is excited by a toroidal excitation winding 14 preferably wound about the core.

Disposed over ferromagnetic core 12 and excitation winding 14 are a pair of mutually perpendicular signal windings 16 and 18 which define a signal winding assembly.

Formed on base element 10 are a plurality of gold plated soldering pads 19 for termination of the various windings. It is appreciated that the entire apparatus shown in Fig. 1 is encapsulated after assembly and connection in a sealant, such as RTV.

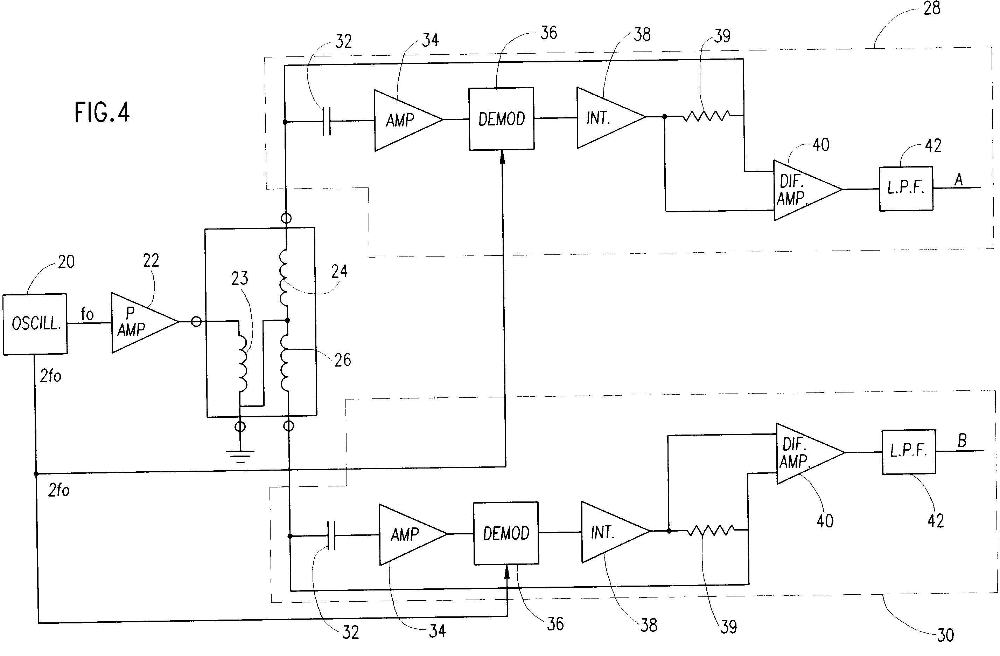

Reference is now made to Fig. 4, which illustrates, in simplified block diagram form, the electrical circuitry of the flux gate magnetometer of the present invention.

As seen in Fig. 4, an oscillator 20 provides an excitation output at a first frequency, typically 20 KHz via a power amplifier 22 to a grounded excitation coil 23, such as excitation winding 14 (Figs. 1 - 3).

A pair of series connected sensing coils 24 and 26, such as sensing windings 16 and 18 of Figs 1-3, have their junction coupled to ground and to coil 23, as shown and their other ends coupled to identical sensing circuits 28 and 30. A voltage is induced in each coil which is proportional to the magnitude of that component of an external static magnetic field which is perpendicular to the coil. This voltage contains mainly even components of the excitation voltage, with a large second harmonic component.

Sensing circuits 28 and 30 each include a capacitor 32 which passes the induced signal voltage from the sensing winding to an amplifier 34, and directs a feedback DC current as described hereinbelow to the sensing coil 24 or 26 without interfering with the amplifier input. Amplifier 34 provides an amplified output to a demodulator 36, which receives an output of oscillator 20 at a second frequency which is twice the first frequency, as is common in conventional flux-gate sensors.

The DC component of the output of demodulator 36 is amplified by an integrator 38 and applied via a resistor 39 to feed back a current to the sensing coil 24 or 26 with a polarity such that the resulting magnetic field tends to oppose the ambient static measured magnetic field. This current is sensed by means of a differential amplifier 40. The output of the differential amplifier 40 is supplied via a low pass filter 42 to provide a component of the sensed magnetic field. If the sensor is aligned horizontally, the two signal outputs of the low pass filters 42 represent the sine and cosine of the azimuth of the sensor. If the sensor is otherwise aligned, the angle is that of the component of the static field in the plane of the axes of the sensor coils.

The sine and cosine outputs may be displayed in any suitable analog or digital display to provide a compass reading indication or may be used to compute the direction.

Since the integrator 38 provides an essentially infinite gain for the DC component of the demodulated signal, i.e., the second harmonic signal, the feedback action provided by the circuitry of Fig. 4 provides an essentially zero sum of the sensed and generated fields. The feedback current is thus operative to essentially cancel the static field and thus the feedback current is proportional to the measured field.

The output is therefore independent of the magnetic properties of the core and its temperature and nonlinear effects and is also not effected by the stability of the oscillator. The output will be substantially dependent only on the mechanical dimensions and the number of turns of coils 24, which provides a fixed scale factor.

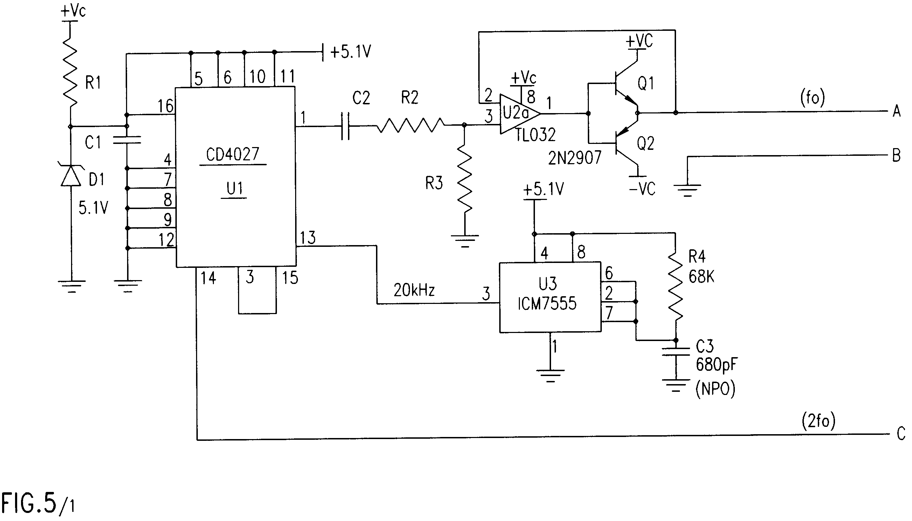

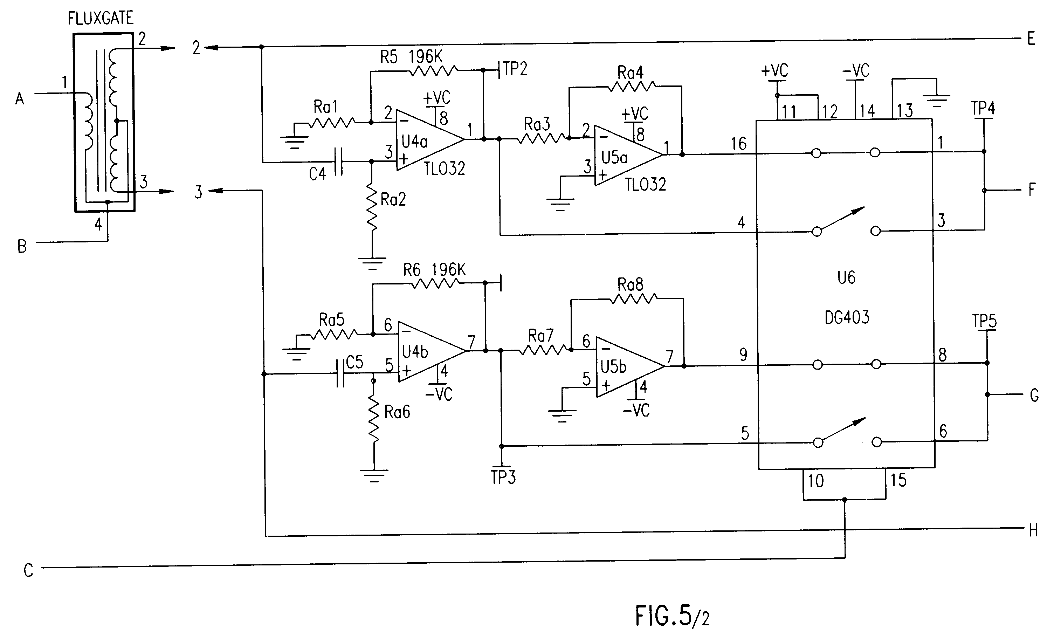

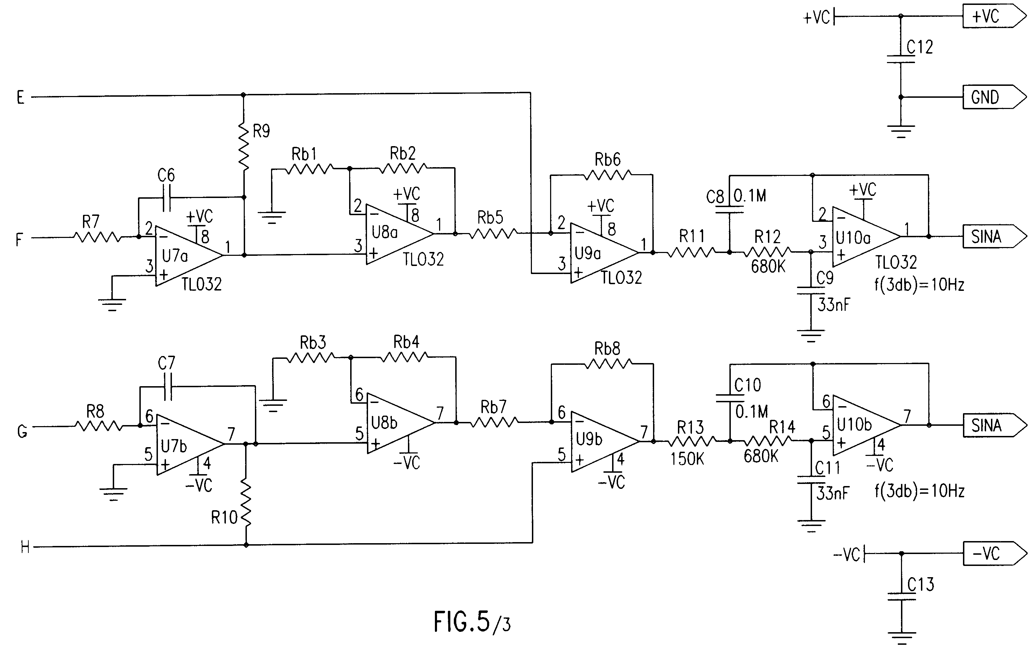

Fig. 5 is a detailed schematic illustration of the apparatus of Fig. 4. Sheet 5/1 shows a detailed schematic diagram of the oscillator 20 and amplifier 22 where output "A" is at fo and output "C" is at frequency 2fo. Sheet 5/2 shows the fluxgate (reference 23, 24 and 25 of Fig. 4) coupling capacitors 32 (C4 and C5 on Fig. 5/2) and amplifiers 34 which are represented on Fig. 5/2 by amplifiers U4 and U5. U6 is a demodulator (reference 36 on Fig. 4) which receives its demodulating signal from the 2fo output of the oscillator. Also shown on Fig. 5/2 are the feedback paths for the DC feedback current (E to 2 and H to 3).

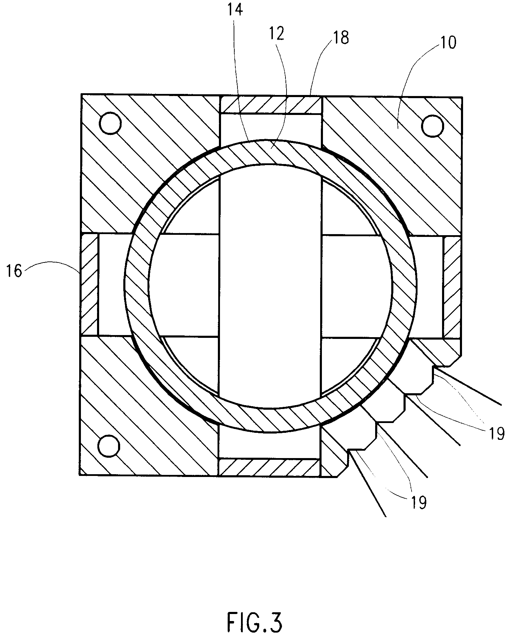

Fig. 5/3 shows an integrator (U7) which corresponds to integrator 38 on Fig. 4. R9 is a feedback resistor (reference number 39 on Fig. 4) for feeding back the current to the sensing coils. U8 and U9 form a differential amplifier (reference 40 on Fig. 4) which converts the feedback current to a voltage. This voltage is filtered to remove any residual AC by a low pass filter formed by the circuit centered on U10 (reference 42 on Fig. 4).

It will be appreciated by persons skilled in the art that the present invention is not limited by what has been particularly shown and described hereinabove. Rather the scope of the present invention is defined only by the claims which follow:

## Claims

1. A temperature stabilized flux-gate magnetometer comprising:
a core having a non-linear magnetization curve;
an excitation winding operatively associated with the core;
an oscillator providing an AC excitation signal to the excitation winding;
a signal winding operatively associated with the core and providing an AC output signal generally proportional to the ambient magnetic field at the location of said core;
means for extracting from said AC output signal a magnetic field dependent DC signal;
means for feeding back said magnetic field dependent signal to said signal winding in order to generate at the core a magnetic field substantially opposite in sense and substantially equal in magnitude to the ambient magnetic field; and
means for sensing a characteristic of said magnetic field dependent signal to provide an output indication of the ambient magnetic field at said core.

2. Apparatus according to claim 1 and wherein said signal characteristic is the current being fed back to said signal winding.

3. Apparatus according to either of the preceding claims and wherein said core is a toroidal core.

4. Apparatus according to claim 3 and wherein said signal winding and said toroidal core are arranged in mutually perpendicular planes.

5. Apparatus according to any of the preceding claims and including a second signal winding disposed in a different plane from said signal winding.

6. Apparatus according to claim 5 and wherein said signal winding and said second signal winding are disposed in generally mutually perpendicular planes.

7. Apparatus according to any of the preceding claims wherein the core is made of a ferromagnetic material.
